# EUROPÄISCHE PATENTANMELDUNG

(11) **EP 2 548 734 A1**
(43) Veröffentlichungstag der Anmeldung: **23.01.2013**
(21) Anmeldenummer: 12173735.7
(22) Anmeldetag: 27.06.2012
(51) Int. Cl.: B32B 18/00

(54) **Keramische Mehrlagenstruktur und Verfahren zur Herstellung derselben**

(30) Priorität: 18.07.2011 US 201161508707 P
(71) Anmelder: Micro Systems Engineering GmbH, 95180 Berg (DE); Technische Universität Wien, 1040 Wien (AT)
(72) Erfinder: Haas, Thomas, 95180 Berg (DE); Schwanke, Dieter, 95030 Hof (DE); Bittner, Achim, 96224 Burgkundstadt (DE); Schmid, Ulrich, 1140 Wien (AT)
(74) Vertreter: Lindner-Vogt, Karin L.

(57) **Zusammenfassung**

Es wird ein einfaches und kostengünstiges Verfahren zur Herstellung einer keramischen Mehrlagenanordnung unter Verwendung einer ersten Grünfolie (1) enthaltend ein keramisches Material mit den folgenden Schritten angegeben:
a) Erzeugen mindestens eines von der Oberfläche der ersten Grünfolie (1) ausgehenden porösen Bereichs (8) in der ersten Grünfolie (1),
b) abschnittsweises Aufbringen einer ersten Schicht (10) auf die Oberfläche der ersten Grünfolie (1), wobei ein Abschnitt der ersten Schicht (10) oberhalb des in Schritt a) erzeugten mindestens einen porösen Bereichs (8) angeordnet ist,
c) Anordnung mindestens einer weiteren Grünfolie (12) auf der mit der Glasschicht (10) versehenen Oberfläche der ersten Grünfolie (1),
d) Laminieren der ersten Grünfolie (1) und der mindestens einen weiteren Grünfolie (12) zur Bildung eines Grünfolienverbunds,
e) Sintern des Grünfolienverbunds.

Ferner wird eine keramische Mehrlagenanordnung herstellbar nach dem obigen Verfahren erläutert.

## Beschreibung

Die Erfindung betrifft eine keramische Mehrlagenanordnung sowie ein Verfahren zur Herstellung einer solchen.

Mehrschichtige keramische Anordnungen werden in verschiedenen Bereichen eingesetzt, insbesondere für mikroelektronische Bauteile, beispielsweise in der Telekommunikation, zur Herstellung von hochintegrierten Drucksensoren oder anderen Sensoren, im Bereich der Hochfrequenztechnik oder für die Herstellung von mikrofluidischen Komponenten.

Eine wichtige und kostengünstige zur Herstellung von derartigen keramischen Mehrlagenanordnungen ist die sogenannte "Low Temperature Cofired Ceramics"- Technologie, welche nachfolgend kurz als LTCC-Technologie bezeichnet wird. Hierbei werden auf ungebrannten Keramikfolien (Grünfolien) die benötigten Strukturen ein- oder aufgebracht, beispielsweise Leiterbahnen, Ausnehmungen, Kondensatoren, Widerstände, Spulen oder Durchkontaktierungen. Diese Grünfolien werden dabei einzeln strukturiert und anschließend gestapelt und laminiert. Danach wird der laminierte Grünfolienverbund gesintert.

Für verschiedene Anwendungen, beispielsweise für Fluid- oder Sensoranwendungen, werden in einer solchen Mehrlagenanordnung Kanalstrukturen oder andere, in ihrer Größe entsprechend angepasste Hohlräume benötigt.

Um miniaturisierte Kanalstrukturen zu erzeugen, werden nach herkömmlichen Verfahren in solche Grünfolien mittels Stanz-, Laser- oder Prägetechnik Kanalstrukturen eingebracht, welche bei den nachfolgenden Prozessschritten durch graphithaltige Pasten oder Folien bzw. unter Verwendung von organischen Materialien, wie Polymethylmethacrylat (PMMA), stabilisiert werden müssen. Das Stabilisierungsmaterial entweicht während des Sinterprozesses. Mit den bekannten Verfahren zur Herstellung von Kanalstrukturen lassen sich typischerweise Strukturen größer als 100 µm (lateral) und maximal 20 µm (vertikal) erzeugen. Viele Anwendungen erfordern jedoch Kanalstrukturen mit hierzu deutlich reduzierten lateralen als auch vertikalen Abmessungen, um die Dielektrizitätskonstante optimal einzustellen. Ferner ist es von Nachteil, dass bei dem bekannten Vorgehen die Flüchtigkeit des Stabilisierungsmaterials auf den Flüssigphasensinterprozess bzw. auf das Erstarren der Glasphase abgestimmt werden muss, um ein vollständiges Entweichen des Stabilisierungsmaterials zu gewährleisten.

Die Aufgabe der vorliegenden Erfindung besteht demnach darin, ein einfaches und kostengünstiges Verfahren zur Herstellung einer keramischen Mehrlagenanordnung anzugeben, mit dem Hohlräume und somit Kanäle oder Membranstrukturen erzeugt werden können, die Abmessungen von minimal wenigen µm (horizontal und/oder vertikal), maximal typischerweise einige 100 µm (horizontal) oder einer Tapelage (vertikal) aufweisen und nicht die oben geschilderten Probleme hinsichtlich des Stabilisierungsmaterials aufweisen. Die Aufgabe besteht ferner darin, eine entsprechende Mehrlagenanordnung anzugeben.

Die obige Aufgabe wird gelöst durch ein Verfahren zur Herstellung einer keramischen Mehrlagenanordnung unter Verwendung einer ersten Grünfolie enthaltend ein keramisches Material mit den folgenden Schritten:
a) Erzeugen mindestens eines von der Oberfläche der ersten Grünfolie ausgehenden porösen Bereichs in der ersten Grünfolie,
b) abschnittsweises Aufbringen einer ersten Schicht auf die Oberfläche der ersten Grünfolie, wobei ein Abschnitt der ersten Schicht oberhalb des in Schritt a) erzeugten mindestens einen porösen Bereichs angeordnet ist,
c) Anordnung mindestens einer weiteren Grünfolie auf der mit der ersten Schicht versehenen Oberfläche der ersten Grünfolie,
d) Laminieren der ersten Grünfolie und der mindestens einen weiteren Grünfolie zur Bildung eines Grünfolienverbunds,
e) Sintern des Grünfolienverbunds.

In einem Ausführungsbeispiel der vorliegenden Erfindung ist das keramische Material der ersten Grünfolie mehrphasig ausgebildet, d.h. es weist eine erste Phase und mindestens eine zweite Phase auf.

Bei dem erfindungsgemäßen Verfahren werden in der ersten Grünfolie zunächst lokal mindestens ein poröser Bereich erzeugt, welcher von der Oberfläche der ersten Grünfolie ausgeht, wobei in einem Ausführungsbeispiel der mindestens eine poröse Bereich durch einen selektiven Ätzvorgang hergestellt wird, beispielsweise durch Verwendung eines geeigneten Ätzmedium in Kombination mit einer ätzresistiven Maske oder durch lokales Applizieren einer Ätzpaste. In diesen porösen Bereichen wird in einem Ausführungsbeispiel der vorliegenden Erfindung selektiv die als Glasphase oder metallische Phase ausgebildete erste Phase der ersten Grünfolie entfernt, beispielsweise mittels eines nasschemischen Ätzvorgangs.

Anschließend wird auf einen Teil der Oberfläche der ersten Grünfolie abschnittsweise eine erste Schicht aufgetragen, vorzugsweise als Paste aufgedruckt. Dabei erfolgt der Auftrag der ersten Schicht auf den Teil der Oberfläche der ersten Grünfolie, von der die porösen Bereiche ausgehen. In einem bevorzugten Ausführungsbeispiel werden Schicht-Abschnitte lediglich oberhalb der porösen Bereiche vorgesehen.

Das erfindungsgemäße Verfahren beruht insbesondere auf der Erkenntnis, dass das Material der ersten Schicht, nachdem eine weitere Grünfolie auf die mit der ersten Schicht versehenen ersten Grünfolie aufgebracht und mit dieser mittels Laminieren zu einem Grünfolienverbund verbunden wurde, während des anschließenden Sinterschrittes flüssig wird oder erweicht und in den darunter liegenden porösen Bereich der ersten Grünfolie eindringt und die zuvor erzeugten Hohlräume des porösen Bereichs wieder ausfüllt. Entsprechend entsteht oberhalb des zuvor porösen Bereiches, d.h. im Volumen der darüber liegenden, weiteren keramischen Folie, die aus der weiteren Grünfolie entsteht, ein Hohlraum, welcher vorzugsweise als Kanal oder Membran ausgebildet ist. Als Membran wird hierbei ein Hohlraum bezeichnet, welcher, verglichen mit seinen lateralen Abmessungen, eine geringe Höhe aufweist. Die Abmessungen dieses Kanals werden bestimmt durch die Größe und Porosität des entsprechenden, in Schritt a) erzeugten porösen Bereichs in der ersten Grünfolie, das Volumen des über dem porösen Bereich angeordneten Abschnitts der ersten Schicht sowie die Schrumpfung der Grünfolien während des Laminierens und des Sinterns. Hierbei ist das Volumen des entsprechenden Abschnitts der ersten Schicht so zu wählen, dass die in dem darunter liegenden porösen Bereich vorliegenden Hohlräume durch das Glasmaterial vollständig ausgefüllt werden und kein Überschuss an Glas auf der Oberfläche der ersten Grünfolie verbleibt.

Zu dem oben beschriebenen Vorgehen ist es von Vorteil, wenn die maximale Sintertemperatur während des Schritts e) oberhalb einer Temperatur liegt, bei der die Phase der ersten Schicht, welche in die Hohlräume des porösen Bereichs eindringen soll, beispielsweise die erste Phase, flüssig wird oder zumindest erweicht.

In einem ersten Ausführungsbeispiel besteht die erste Grünfolie aus einem Glaskeramik-Material und es wird in Schritt a) selektiv die Glasphase (erste Phase) entfernt, vorzugsweise geätzt. In diesem Ausführungsbeispiel enthält die erste Schicht ein Glasmaterial, vorzugsweise ein Glasmaterial, das der in Schritt a) entfernten Glasphase entspricht. Das Glasmaterial der ersten Schicht erweicht während des Sinterschritts e), dringt in die Hohlräume des porösen Bereichs ein und füllt diese auf. Als Resultat entsteht in der weiteren keramischen Folie ein Hohlraum, der als Kanal- oder Membranstruktur ausgebildet ist.

In einem weiteren Ausführungsbeispiel kann die erste Grünfolie auch aus einem Cermet-Material, d.h. aus einem mehrphasigen Werkstoff aus mindestens einer Keramik und mindestens einem Metall, bestehen. Das mindestens eine Metall bildet vorzugsweise die Matrix des Cermet-Materials. Bei diesem Ausführungsbeispiel wird in Schritt a) selektiv eine metallische Phase (erste Phase) entfernt, vorzugsweise geätzt. Die erste Schicht enthält ein metallisches Material, beispielsweise das Metall, welches dem in Schritt a) entfernten Metall entspricht. Das metallische Material der ersten Schicht wird während des Sinterschritts e) flüssig, dringt in die Hohlräume des porösen Bereichs ein und füllt diese auf. Als Resultat entsteht in der darüber liegenden, weiteren keramischen Folie ein Hohlraum, der als Kanal- oder Membranstruktur ausgebildet ist. Dieses Ausführungsbeispiel kann insbesondere zur Realisierung von integrierten Heatsinks dienen.

Bei beiden Ausführungsbeispielen wird das Volumen des Abschnitts der ersten Schicht idealerweise derart gewählt, dass das gesamte Volumen des Abschnitts vollständig durch die Hohlräume des porösen Bereichs aufgenommen wird und keine Restporosität in dem porösen Bereich verbleibt. Hierdurch wird vermieden, dass Material der ersten Schicht im Bereich des Hohlraums verbleibt, welcher in der weiteren Folie ausgebildet wird, dort gegebenenfalls ungleichmäßig verteilt vorliegt, und dass im (ursprünglich) porösen Bereich Konzentrationsunterschiede zu dem umliegenden Material der keramischen Folie, die aus der ersten Grünfolie entsteht, vorhanden sind.

In einem Ausführungsbeispiel der vorliegenden Erfindung wird der mindestens eine poröse Bereich in der ersten Grünfolie mittels Anordnung einer mit entsprechenden durchgehenden Öffnungen versehenen Schutzschicht, die eine ätzresistive Maske in Form einer vorstrukturierten Schablone sein kann, auf der ersten Grünfolie und anschließender Anwendung eines Ätzmediums, welches durch die durchgehenden Öffnungen in der ätzresistiven Maske hindurch in die erste Grünfolie eindringt, erzeugt. Das Ätzmedium entfernt nur in dem Bereich oder den Bereichen der ersten Grünfolie, welche durch die durchgehenden Öffnungen in der darüber liegenden Schutzschicht zugänglich sind, vorzugsweise selektiv die erste Phase aus der ersten Grünfolie. Dies ist ein besonders einfaches Verfahren, um den mindestens einen porösen Bereich in der ersten Grünfolie zu erzeugen.

In einem Ausführungsbeispiel der Erfindung werden die durchgehenden Öffnungen in der Schutzschicht, welche auf der ersten Grünfolie angeordnet ist, mittels Maskieren der Schutzschicht durch eine Maskierungsschicht und Einätzen der durchgehenden Öffnungen erzeugt. Die Maskierungsschicht weist hierbei entsprechende durchgehende Öffnungen auf, durch welche das Ätzmedium hindurch in die darunter liegende Schutzschicht eindringt und diese entfernt. Hierdurch können so kleine Öffnungen in der Schutzschicht erzeugt werden, dass nach Beendigung des erfindungsgemäßen Verfahrens Hohlräume in der Mehrlagenanordnung mit einer horizontalen (lateralen) Abmessung (Breite, Tiefe) von weniger als 80 µm resultieren.

Die Maskierungsschichten können organische, photostrukturierbare Schutzschicht sein, die nicht zur Stabilität der Kanal/Membranstrukturen dient (wie dies bei PMMA der Fall ist), sondern schon wesentlich früher entweicht. (sprich vor dem Flüssigphasensinterprozess) So kann ein lokales Porosizieren ermöglicht werden. Auch ein Bedrucken der Grünfolie mit organischen Schichten ist denkbar. In diesem Fall wäre beispielsweise das Aufbringen mittels Stempeln möglich.

Alternativ kann die Schutzschicht auf die mit der Glasschicht versehene erste Grünfolie aufgedruckt werden. Die durchgehenden Öffnungen in der Schutzschicht werden hierbei durch entsprechende Strukturierung der Druckplatte erzeugt. Allerdings liegen die horizontalen Abmessungen der mit dieser Schutzschicht erzeugbaren Kanalstrukturen in der resultierenden keramischen Mehrlagenanordnung oberhalb von 80 µm.

Denkbar ist auch der Ansatz, als Schutzschicht eine vorstrukturierte Schablone oder Schattenmaske zu verwenden. Im Sinne der Patentanmeldung ist dies eine dünne Folie - beispielsweise aus Metall oder Keramik - enthaltend Öffnungen, an denen das Ätzmedium durchtreten und die Grünfolien modifizieren kann. Die Schablone oder Schattenmaske, die beispielsweise aus Al₂O₃ oder Silizium besteht, muss zum Grünkörper ausgerichtet werden und eine hohe Ätzresistenz haben. Zusätzlich kann an der der Unterseite der Schablone oder Schattenmaske (also zum Grünkörper hin) eine weiche Schicht, beispielsweise aus Tetrafluorethylen, angeordnet sein. So kann ein verbesserter Kontakt zur Grünfolie hergestellt werden, so dass die Abdichtung zwischen Schablone und Grünfolie verbessert und somit ein laterales Unterätzen des Grünkörpers zu reduziert wird.

Ebenso ist alternativ denkbar, eine vorstrukturierte Schablone in Form einer ätzresistiven, strukturierten organischen Folie zu verwenden, welche auf der Grünfolie auflaminiert oder aufgeklebt wird.

Gemäß einer weiteren Ausführung wird keine Schutzschicht aufgebracht, sondern das Ätzmedium lokal aufgebracht, beispielsweise mittels hochviskoser Ätzpasten. Das Aufbringen erfolgt beispielsweise mittels Drucken einer Ätzpaste, die beispielsweise Flusssäure enthält und lokal damit die Glasmatrix angreift. Alternativ kann das Ätzmedium auch aufgestempelt werden.

Wie oben bereits beschrieben wurde, enthält die erste Schicht in einem Ausführungsbeispiel eine Glasphase oder eine metallische Phase, welche vorzugsweise der in Schritt a) selektiv entfernten ersten Phase entspricht.

Die obige Aufgabe wird außerdem gelöst durch eine keramische Mehrlagenanordnung herstellbar oder hergestellt nach einem oben angegebenen Verfahren.

Der Vorteil einer derartigen keramischen Mehrlagenanordnung besteht darin, dass sehr kleine Hohlräume, d.h. Kanäle oder Membranen, mit beliebigen Abmessungen bis maximal zur Schichtdicke der aus der aufgebrachten Glasschicht entstandenen Folie (vertikal) und/oder in der Breite bzw. Tiefe (horizontal oder lateral) von wenigen µm bis zu beliebigen Breiten produziert werden können. Hierdurch können komplexe Membranstrukturen, welche beispielsweise in hochintegrierten Drucksensoren angewendet werden können, erzeugt werden. Auch für Fluid- oder Sensoranwendungen sind solche feine Kanalstrukturen einsetzbar. Ferner können derartige Hohlräume auch im Bereich von Hochfrequenz-Bauelementen verwendet werden, da in den Hohlräumen durch die eingeschlossene Gasatmosphäre (z.B. Luft) gezielt Bereiche mit einer geringen Dielektrizitätskonstante im Keramikkörper verteilt vorliegen und sich somit im Mittel eine geringere, effektive Dielektrizitätskonstante zwischen den Antennenelementen und der Massefläche vorliegt. Durch die damit geringere, kapazitive Koppelung in das Substrat kann die Performance der Antennenelemente verbessert werden.

Erfindungsgemäß weist eine derartige keramische Mehrlagenanordnung einen oder mehrere Hohlräume mit einer Abmessung von mindestens 10 µm Breite (horizontale Abmessung) und/oder mindestens 5 µm Höhe (vertikale Abmessung) auf. Bei Verwendung des erfindungsgemäßen Verfahrens wird zudem eine hohe Formstabilität des oder der Hohlräume im Vergleich zur Verwendung von zusätzlichen organischen Materialien erreicht, da der oder die Hohlräume erst während der Sinterphase und nicht schon während der Entbinderungsphase gebildet wird, da die erste Schicht idealerweise vollständig in dem porösen Bereich der ersten Grünfolie aufgenommen wird. Somit kann sichergestellt werden, dass eine vergleichsweise ebene Oberflächentopographie auf dem LTCC-Modul trotz der vorhandenen Hohlräume erzielt werden kann, sodass siebgedruckte Strukturen auf der LTCC-Moduloberfläche mit hoher Strukturtreue und Positioniergenauigkeit durchgeführt werden können.

Weitere Ziele, Merkmale, Vorteile und Anwendungsmöglichkeiten der Erfindung ergeben sich auch aus der nachfolgenden Beschreibung von Ausführungsbeispielen des erfindungsgemäßen Verfahrens bzw. der erfindungsgemäßen keramischen Mehrlagenanordnung anhand von Figuren. Alle beschriebenen und/oder bildlich dargestellten Merkmale bilden für sich oder in beliebiger Kombination den Gegenstand der vorliegenden Erfindung, unabhängig von ihrer Zusammenfassung in den Ansprüchen oder deren Rückbezüge.

Es zeigen schematisch die folgenden Querschnitte in:
- Fig. 1: eine erste Grünfolie im Ausgangszustand,
- Fig. 2: die erste Grünfolie mit einer Schutzschicht,
- Fig. 3: das System gemäß Fig. 2 mit einem Ätzmedium,
- Fig. 4: das System gemäß Fig. 3 am Ende des Ätzvorgangs,
- Fig. 5: die erste Grünfolie nach Entfernen des Ätzmediums und der Ätzmaske,
- Fig. 6: die erste Grünfolie nach abschnittsweisem Auftragen einer Glasschicht,
- Fig. 7: das System gemäß Fig. 6 mit einer weiteren Grünfolie und
- Fig. 8: die gesinterte erfindungsgemäße keramische Mehrlagenanordnung.

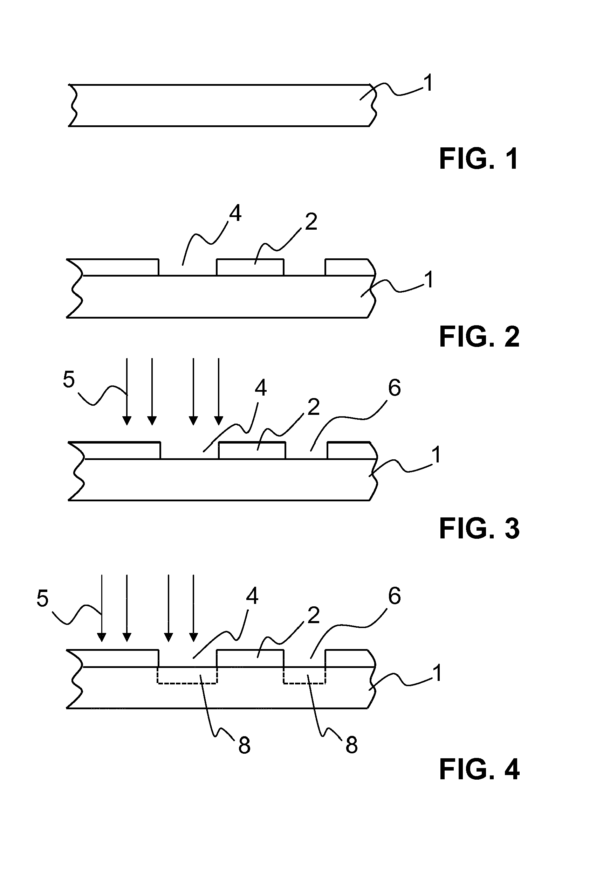

Fig. 1 zeigt eine erste Grünfolie 1, welche aus einem Glaskeramik-Material besteht, als Querschnitt im Ausgangszustand. Als erste Grünfolie 1 wird beispielsweise das 951 Low-Temperature Cofire Dielectric Tape der Fa. Dupont mit einer Dicke zwischen 100 µm und 270 µm verwendet. Diese erste Grünfolie 1 wird anschließend mit einer vorstrukturierten Schablone oder Schattenmaske 2 mit "weicher" Unterseite versehen, welche durchgehende Öffnungen 4 aufweist. Die "weiche" Unterseite dient dazu, sich der Oberflächenkontur des Green Tapes anzupassen. Diese "weiche" Unterseite - also die der Grünfolie zugewandte Seite - kann beispielsweise aus Tetrafluorethylen gebildet sein. Anstelle einer Schablone, welche die Strukturen schützt, ist auch die Verwendung von Stempeln bzw. das Aufstempeln des Ätzmediums denkbar. Ebenso kann die Verwendung von aufgedruckten Schutzlacken vorgesehen sein.

Alternativ kann die Schutzlack-Schicht 2 auch zunächst als durchgehende Maskierungsschicht, beispielsweise auch mittels Drucken mit einem bekannten Siebdruckverfahren, auf die erste Grünfolie 1 aufgebracht werden. Die Maskierungsschicht weist entsprechende Strukturen (durchgehende Öffnungen) auf, durch die ein Ätzmedium (z.B. Flusssäure) hindurch die Schutzlack-Schicht 2 derart ätzt, dass die in Fig. 2 gezeigten durchgehenden Öffnungen 4 entstehen.

Dann wird die in Fig. 2 dargestellte Grünfolie 1 mit der vorstrukturierten Schablone 2 enthaltend die durchgehenden Öffnungen 4 geätzt, wobei, wie in Fig. 3 gezeigt, das Ätzmedium 6 von oben (siehe Pfeile 5) auf die Oberfläche der Schablone 2 bzw. der Grünfolie 1 aufgebracht wird. Das Ätzmedium 6, beispielsweise die bei Raumtemperatur aufgebrachte Flusssäure, dringt durch die durchgehenden Öffnungen 4 in die Grünfolie 1 ein. Das Ätzmedium 6 ist derart gewählt, dass es bei diesem Ausführungsbeispiel aus der Glaskeramik-Grünfolie 1 die Glasphase selektiv heraus ätzt, so dass die in den Figuren 4 bis 7 dargestellten porösen Bereiche 8 in der Grünfolie 1 entstehen.

Bei einer alternativen Verwendung von Cermet-Material (beispielsweise ein Hartmetall aus Wolframcarbid mit einer Cobalt-Matrix) als erste Grünfolie 1 wird mittels des Ätzmediums vorzugsweise eine metallische Phase (im genannten Beispiel das metallische Cobalt) selektiv herausgeätzt.

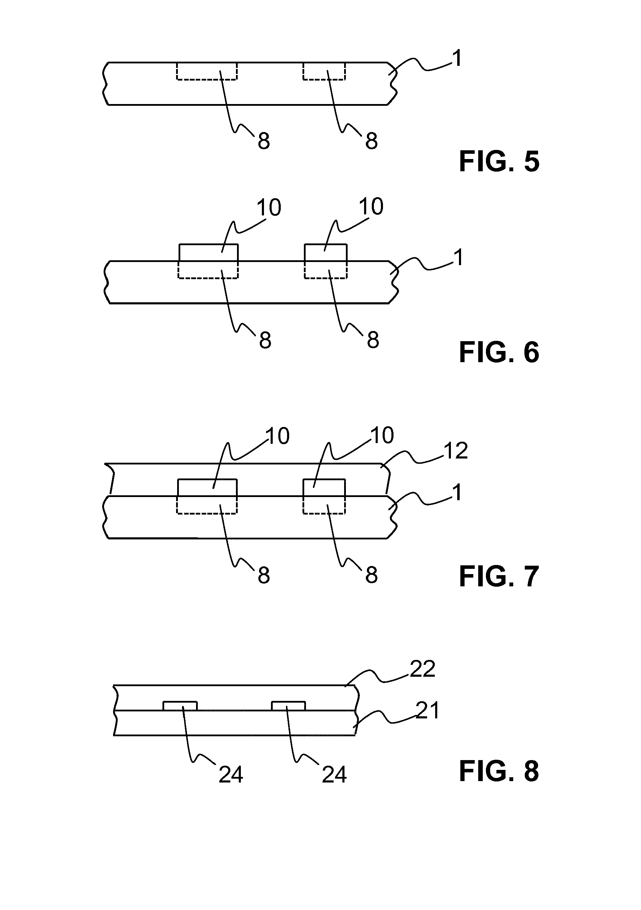

Anschließend wird das Ätzmedium 6 beispielsweise mittels Wasser abgewaschen und die vorstrukturierte Ätzmaske 2 (z.B. Schablone) entfernt. Falls eine organisch basierte Ätzmaske verwendet wird, erfolgt das Entfernen dieser in diesem Ausführungsbeispiel über eine Veraschung in einem ca. 300°C warmen Luftstrom oder einer ebenso warmen Luftatmosphäre. Denkbar sind auch andere thermische Verfahren. Hierdurch entsteht die in Fig. 5 gezeigte Grünfolie 1 mit porösen Bereichen 8.

Nun wird auf einem Teil der Oberfläche der Grünfolie 1, insbesondere dort, wo die Oberfläche in den Bereichen 8 porös ist, abschnittsweise eine Glasschicht 10 (erste Schicht) angeordnet, z.B. mittels Siebdruck aufgedruckt, so dass die in Fig. 6 dargestellte Anordnung entsteht. Beispielsweise werden die Materialien 9615, 5137, QQ550 oder QQ620 der Fa. Dupont als Glasschicht 10 verwendet. Die Glasschicht 10 kann dabei auch in die Bereiche der Oberfläche der Grünfolie 1 hineinreichen, welche nicht porös sind. Das Volumen der Abschnitte der Glasschicht 10 wird derart gewählt, dass in dem nachfolgenden Sinterschritt das gesamte Material des zu einem porösen Bereich 8 zugeordneten Abschnitts der Glasschicht 10 durch diesen aufgenommen wird und diesen wieder ausfüllt.

Anschließend wird eine zweite Grünfolie 12 auf der mit der Glasschicht 10 versehenen Oberfläche der ersten Grünfolie 1 angeordnet (siehe Fig. 7). Die beiden Grünfolien 1, 12 werden dann isostatisch oder uniaxial bei 2000 bis 6000 PSI für 3 bis 7 Minuten laminiert - abhängig vom gewünschten Schrumpfungsverhalten. Anschließend wird ein material- oder produktabhängiger Sinterschritt vollzogen, welcher beispielsweise die für LTCC-Material typische Peaktemperatur von 875°C aufweist.

Während des Sinterschrittes wird das Material der Glasschicht 10 flüssig, dringt in die Hohlräume der porösen Bereiche 8 ein und füllt diese wieder aus. Entsprechend entstehen in der darüber liegenden Grünfolie 12 Hohlräume 24. Folglich weist die in Fig. 8 gezeigte gesinterte keramische und erfindungsgemäße Mehrlagenstruktur eine erste Keramikfolie 21, welche aus der ersten Grünfolie 1 entstanden ist, eine zweite Keramikfolie 22, welche sich aus der zweiten Grünfolie 12 ergibt, sowie Hohlräume 24 auf, die nach dem Einwandern des Glasmaterials der Glasschicht 10 in die Hohlräume der porösen Bereiche 8 zurück geblieben sind. Die mit dem erfindungsgemäßen Verfahren erzeugten Hohlräume 24 in der Mehrlagenanordnung weisen Abmessungen von wenigen µm bis einige mm horizontal (lateral) und wenige µm bis 100 µm vertikal auf (Richtungen wie in Fig. 8 gezeigt).

In dem in den Figuren 1 bis 8 dargestellten Ausführungsbeispielen des erfindungsgemä-βen Verfahrens und der erfindungsgemäßen Mehrlagenanordnung wird eine 2-lagige Anordnung erläutert. Entsprechend kann das Verfahren auch für Anordnungen mit mehr als 2 Schichten ausgeführt werden.

Das obige Verfahren ist ein einfaches, kostengünstiges und vielseitig anwendbares Verfahren, mit dem Hohlraumstrukturen mit Abmessungen von wenigen µm lateral und/oder vertikal erzeugt werden können.

### Bezugszeichenliste:

- 1: erste Grünfolie
- 2: vorstrukturierte Ätzmaske
- 4: durchgehende Öffnung in der vorstrukturierten Ätzmaske 2
- 5: Pfeil
- 6: Ätzmedium
- 8: poröser Bereich
- 10: Glasschicht
- 12: zweite Grünfolie
- 21: erste Keramikfolie
- 22: zweite Keramikfolie
- 24: Hohlraum

## Patentansprüche

1. Verfahren zur Herstellung einer keramischen Mehrlagenanordnung unter Verwendung einer ersten Grünfolie (1) enthaltend ein keramisches Material mit den folgenden Schritten:
a) Erzeugen mindestens eines von der Oberfläche der ersten Grünfolie (1) ausgehenden porösen Bereichs (8) in der ersten Grünfolie (1),
b) abschnittsweises Aufbringen einer ersten Schicht (10) auf die Oberfläche der ersten Grünfolie (1), wobei ein Abschnitt der ersten Schicht (10) oberhalb des in Schritt a) erzeugten mindestens einen porösen Bereichs (8) angeordnet ist,
c) Anordnung mindestens einer weiteren Grünfolie (12) auf der mit der ersten Schicht (10) versehenen Oberfläche der ersten Grünfolie (1),
d) Laminieren der ersten Grünfolie (1) und der mindestens einen weiteren Grünfolie (12) zur Bildung eines Crrünfolienverbunds,
e) Sintern des Grünfolienverbunds.

2. Verfahren nach Anspruch 1, **dadurch gekennzeichnet, dass** das keramische Material eine erste Phase und mindestens eine zweite Phase aufweist.

3. Verfahren nach Anspruch 1 oder 2, **dadurch gekennzeichnet, dass** der mindestens eine poröse Bereich (8) in der ersten Grünfolie (1) dadurch erzeugt wird, dass selektiv die erste Phase in diesem Bereich entfernt wird, beispielsweise eine Glasphase oder eine metallische Phase, beispielsweise mittels Ätzen.

4. Verfahren nach einem der Ansprüche 1 bis 3, **dadurch gekennzeichnet, dass** der mindestens eine poröse Bereich (8) in der ersten Grünfolie (1) mittels Anordnung einer mit einer entsprechenden durchgehenden Öffnung (4) versehenen Ätzmaske (2) auf der ersten Grünfolie (1) und anschließender Anwendung eines Ätzmediums (6), welches durch die durchgehende Öffnung (4) in der Ätzmaske (2) hindurch in die erste Grünfolie (1) eindringt, erzeugt wird, wobei das Ätzmedium (6) vorzugsweise selektiv die erste Phase ätzt.

5. Verfahren nach einem der Ansprüche 1 bis 4, **dadurch gekennzeichnet, dass** die erste Schicht die erste Phase enthält, vorzugsweise eine Glasphase oder eine metallische Phase.

6. Verfahren nach einem der Ansprüche 1 bis 5, **dadurch gekennzeichnet, dass** die erste Schicht (10) aufgedruckt wird.

7. Keramische Mehrlagenanordnung hergestellt nach dem Verfahren nach Anspruch 1.

8. Keramische Mehrlagenanordnung nach Anspruch 7, **dadurch gekennzeichnet, dass** die Anordnung einen oder mehrere Hohlräume (24) mit einer Abmessung von mindestens 10 µm Breite und mindestens 5 µm Höhe aufweist.
